# EUROPEAN PATENT APPLICATION

(11) **EP 1 074 489 A1**
(43) Date of publication of application: **07.02.2001**
(21) Application number: 99114789.3
(22) Date of filing: 28.07.1999
(51) Int. Cl.: B65G 9/00, H01L 21/00

(54) **Arrangement and method for manually moving a container for storing objects through an environment**

(71) Applicant: Infineon Technologies AG, 81541 München (DE); Semiconductor 300 GmbH & Co. KG, 01074 Dresden (DE); MOTOROLA, INC., Schaumburg, IL 60196 (US)
(72) Inventor: Missale, Reiner, 93155 Hemau (DE); Haris, Clinton, 01324 Dresden (DE); Frisa, Larry Edward, 01309 Dresden (DE)
(74) Representative: Zedlitz, Peter, Dipl.-Inf.

(57) **Abstract**

It is described an arrangement (20) for manually moving a container (16) for storing objects, particularly for storing disklike objects such as wafers, flat panels or CDs, through an environment, particularly through a fabrication with clean room class one or less. In order to allow an operator (18) to move a container (16) great distances without any problems, the arrangement (20) comprises a system (21) of overhead tracks (22) which are attached to the ceiling of the environment and a device (25) for supporting and moving said container (16), said device (25) comprising a conveying means (26) which is movable along said tracks (22) and a holding means (28) for holding said container (16). Said holding means (28) is attached to said conveying means (26) via a suspension means (29), for example a rope, cord or line. The container (16) is moved by manually pushing or pulling a handle (30), which is connected to suspension means (29).

## Description

The present invention relates to an arrangement and a method for manually moving a container for storing objects, particularly for storing disklike objects such as wafers, flat panels or CDs, through an environment, particularly through a fabrication.

In the technical field of manufacturing and processing wafers (for example disks on the basis of silicon), flat panels or CDs in semiconductor industries it is common and necessary that wafers are frequently moved between different locations such as processing stations. Moreover, there is a need to store said wafers in specific storage areas, when they are not needed for the moment or before they are moved to a next processing station, respectively.

Usually, wafers are stored and processed under minienvironment conditions. In light of the present invention, the term minienvironment defines a localized environment created by an enclosure to isolate a product from contamination and/or people. The requirements for such minienvironments are set forth in SEMI-standards E44 for example.

During the transportation, and any processing and storage steps or conditions, said wafers are usually stored in special containers, for example in socalled Front-Opening-Unified-Pods (FOUP). However, theses containers are heavy and difficult to transport by an operator, especially when they are adapted to store wafers with a diameter up to and beyond 300mm. In order to move said containers within an environment or fabrication from one location to another location, they have to be carried by an operator and by hand. Since there might exist great distances between different processing or storing locations, manual carrying of containers by an operator is very disadvantageous. Furthermore, there is a high risk for the operator to get injured, or for the objects stored within the container to get damaged during the transportation between two different locations.

In view of the prior art it is an object of the present invention to provide an arrangement and a method for manually moving a container for storing objects through an environment which overcomes the aforementioned drawbacks.

This object is solved by the arrangement according to independent claim 1 and by the method according to independent claim 11. Further advantages, features, aspects and details of the invention are evident from the dependent claims, the description and the accompanying drawings.

According to the first aspect of the invention, an arrangement for manually moving a container for storing objects, particularly for storing disklike objects such as wafers, flat panels or CDs, through an environment, particularly through a fabrication, is provided, said arrangement comprising a system of overhead tracks and a device for supporting and moving said container, said device comprising a conveying means which is movable along said tracks and a holding means for holding said container, said holding means being attached to said conveying means via a suspension means.

The arrangement according to the present invention allows the operator to move the container or containers great distances without any threat of injury, since it offers support to the operator during the transport of the container. The container is held by the holding means and therefore, the operator does not have to carry the container by hand. Through the system of tracks, which is preferably attached to the ceiling of the environment or fabrication and through the device for supporting and moving said container, which is movably attached to the system of tracks, the container being held by said holding means can be moved very easy by the operator to every desired location within said environment, which may be a processing station, a tool, a storage area or the like.

Therefore, the arrangement according to the present invention may be used according to the basic idea of "moving a curtain".

Thus, the arrangement according to the present invention facilitates the handling of a container and keeps the ease of handling simple. Additionally, the arrangement can be applied with cheap an proven components. For that reason, the arrangement is very low in costs.

The arrangement according to the present invention preferably comprises one system of tracks and one device for supporting and moving a container along the tracks. However, it is also possible to provide an arrangement comprising more than one of those devices.

In case, that the arrangement is used in the field of semicondutor manufacturing, the different elements of the arrangement are preferably made of materials for clean room class one or less.

Preferably, the holding means may be formed as a gripper. The gripper can have any configuration which is capable of holding the container. In a preferred embodiment, the gripper has a U-shaped configuration. However, the present invention is not limited to the described specific embodiments. All kinds of holding means can be used which are able to hold the container during its transport.

Also, the invention is not limited to specific kinds of objects, which can be stored within said containers. Preferably, all sorts of objects can be stored within said container which have to be stored under minienvironment conditions. The term "minienvironment" has already been explained in the introducory part of the description. Advantageously, the arrangement is used to store disklike objects such as wafers, for example wafers with a diameter up to and beyond 300mm, flat panels or CDs.

Advantageously, the tracks are formed as profiled guiding rails. The invention is not limited to specific types of profiles. The profiles can have such a configuration or cross-section that the conveying means of the device for supporting and moving said container is guided within or outside of said profiled guiding rail. In a preferred embodiment, the conveying means is guided within said profiles. In this case, there is no risk that the conveying means might get damaged.

Preferably, the system of overhead tracks may be comprised of one or more branching points.

According to the present invention there is no need for a system of tracks with only one special configuration. The system of tracks can be adapted to the environment, for example the fabrication, wherein it is installed. The different tracks are arranged in a manner, that every processing station, tool, storage area or the like can be reached by the device for supporting and moving said container. Therefore, the system of tracks may comprise one or more branching points which connect the different tracks to become said system of tracks. In this case, the different tracks may function as a sort of branches which lead to different locations. The number and configuration of said tracks and said branching points depends on the respective requirements. The different tracks and branching points are preferably mounted at the ceiling of the environment.

Furthermore, said system of tracks may be comprised of one ore more bypass-tracks. The purpose of such bypass-tracks is to move two different containers past one another. In this case, the required number of tracks for moving more than one container at the same time can be minimized. Otherwise, the bypass-tracks may also be used to store the container or containers in case that they are not needed for the moment. The number and configuration of those bypass-tracks depends on the respective requirements.

The aforementioned branching points and bypass-tracks are formed and configurated in line with the tracks, that is preferably as profiled guiding rails.

Advantageously, the conveying means may comprise one or more rollers or wheels. By aid of said rollers or wheels the conveying means is moved inside or outside of said tracks and optionally of said branching points and bypass-tracks, which are preferably formed as profiled guiding rails.

In its simplest configuration, the conveying means may comprise only one roller or wheel. In this case, the tracks, branching points and bypass-tracks may be formed as L-shaped or V-shaped guiding rails. The conveying means can be formed as a hook which is moved along the rails outside of the profile.

In a preferred embodiment, the conveying means comprises two or four rollers or wheels. In the case of four rollers, the conveying means is a kind of cart which can be moved very easy within a profiled guiding rail, shaped respectively. Such a solution is described with respect to the drawings below.

Preferably, the suspension means is formed as a cord, line, rope or the like. Such devices are very easy to manufacture and therefore, very low in cost. Furthermore, such devices are very flexible. In case that the device for supporting and moving a container is not needed, the cord, line or rope can be stored without requiring much storage space. When a cord, line or rope is used as said suspension means, the arrangement does not have any lifting capabilities.

According to another preferred embodiment, said suspension means may be formed as a rod, particularly as a telescopic rod. Such rods are more rigid than a cord, line or rope. Therefore, the risk of a swinging container can be prevented when a rod is used. In case that the rod is formed in telescopic manner, the holding means can be lowered and lifted within a predefined range. Thus, the operator does not have to lift the container by hand, in order to connect it with the holding means.

Furthermore, a handle may be provided, which is preferably attached to said suspension means. Said handle enables the operator to manually push or pull the container along the tracks into the desired direction.

Advantageously, a stabilizing means may be provided for preventing a tilt of said container during its movement. As a suitable stabilizing means, a gyroscope can be used for example, which per se is well known in the art. However, the present invention is not limited to specific types of such stabilizing means. In a preferred embodiment, the stabilizing means can be provided on the top of said container to be moved. Thus, the objects stored within said container can be moved without being rattled and tossed. Furthermore, the container itself can be moved in smooth manner.

Preferably, a control means may be provided, said control means being adapted for controlling the movement of said conveying means at said branching points and/or bypass-tracks. Said control means is preferably attached to said suspension means or to said handle. The control means generally enables the conveying means to change its moving direction in case there is a need of diverting and/or branching.

For example, the control means can operate a switch in the tracks which is located in the area of a branching point. According to another embodiment, the control means can operate a steering within said conveying means in order to turn its rollers or wheels. However, the present invention is not limited to the described examples. The control means may comprise a branching signal wire which is attached with its first end to the suspension means or to the handle and which is attached with its second end to the conveying means.

Furthermore, at least one additional suspension means, for example another cord, line, rope, rod or the like can be provided, being preferably attached to said conveying means. Said additional suspension means can be used additionally to or instead of said aforementioned handle, thus enabling the operator to pull or push the container along the tracks by aid of said additional suspension means. Under these circumstances, one suspension means is used to hang the container and the additional suspension means is used for its movement.

Such an additional suspension means is particularly advantageous if said aforementioned stabilizing means is used. In this case the stabilizing means effects the container hanging down from said conveying means via said first suspension means to be moved in a smooth manner. By use of said additional suspension means, the operator can move the container along said tracks without having a direct contact to the container and thus without influencing the stabilizing procedure.

In a preferred embodiment, said additional suspension means can be identical with said above branching signal wire being part of said control means.

According to another embodiment, one or more tracks can be movably arranged within said system of tracks. Therefore, they are capable of being turned into different directions. In order to move the container into a desired direction, the movable or turnable track, along which the conveying means is presently moved, has to to be turned or shifted in such a manner that it comes in contact and into line with a selected track leading to the desired direction. The shift or turn of said track might be accomplished by aid of said first or second suspension means or by aid of said handle which function as a sort of control means.

Advantageously, the container is a minienvironment container, particularly a Front-Opening-Unified-Pod (FOUP). For example, such a container is defined in SEMI-Standards E44 and E62, the contents thereof are incorporated into the description of the present invention by reference with respect to the FOUPs. The container can also be designed according to SEMI-Standard E47.1, the content of which is incorporated by reference into the description of the present invention. According to said standard, the container has a door and a housing. On the top of the housing a top handling flange may be provided which enables the holding means of the device for supporting and moving said container to grip an hold the container.

According to the second aspect of the present invention, a method is provided for manually moving a container for storing objects through an environment, particularly through a fabrication, by use of an arrangement according to the present invention as described above, said method comprising the steps of:
a) picking up and holding said container by aid of said holding means;
b) conveying said container through said environment such that said device for supporting and moving said container is manually moved via its conveying means along the system of overhead tracks.

Advantageously, said device for supporting and moving said container is manually pushed or pulled by an operator.

For the movement of the container, particularly for a FOUP movement, the operator connects the container with the holding means which is connected to the conveying means via the suspension means.

In a specific embodiment, the operator hangs the container into a gripper hanging down from the system of tracks at the ceiling of the environment via said suspension means being formed as a rope or the like. By use of a suitable stabilizing means, the objects stored within said container are prevented from being rattled or tossed during its movement. Thus, the container can be moved in a very smooth manner. The operator moves the hanging container by manually moving (pushing or pulling) the suspension means (rope) on a handle. The suspension means (rope) will be guided by the conveying means which may be formed as a roller mechanism running along the tracks. The tracks may be formed as profiled rails and the rollers preferably run inside of said profiled rails. By aid of the tracks, a system of branching points and one or more bypass-tracks as well as by aid of the horizontal force exerted by the operator, the container can be moved through the environment to its desired destination along a predefined possibility of routes.

With respect to the advantages, effects and the function of the method according to the present invention it is also referred to the above disclosure of the arrangement according to the present invention.

Advantageously, the aforementioned arrangement and/or the aforementioned method may preferably be used in environments with clean room class one or less. Since a contamination of the handeled and processed objects can be prevented in such environments, the arrangement and the method can preferably be used in semiconductor industry. Nevertheless, the invention can also be used in dirtier environments, especially when containers with minienvironment conditions are used.

The invention will be better understood by reference to the following description of embodiments of the invention taken in conjunction with the accompanying drawings, wherein:
- Fig.1: shows a schematic top view of an arrangement for manually moving a container for storing objects according to the present invention;
- Fig.2: shows a schematic side view of the arrangement according to Fig.1;
- Fig.3: shows a schematic embodiment of a system of tracks;
- Fig.4: shows a schematic view of another embodiment of an arrangement for manually moving a container according to the present invention; and
- Fig.5: shows a detail of the arrangement according to Fig.4.

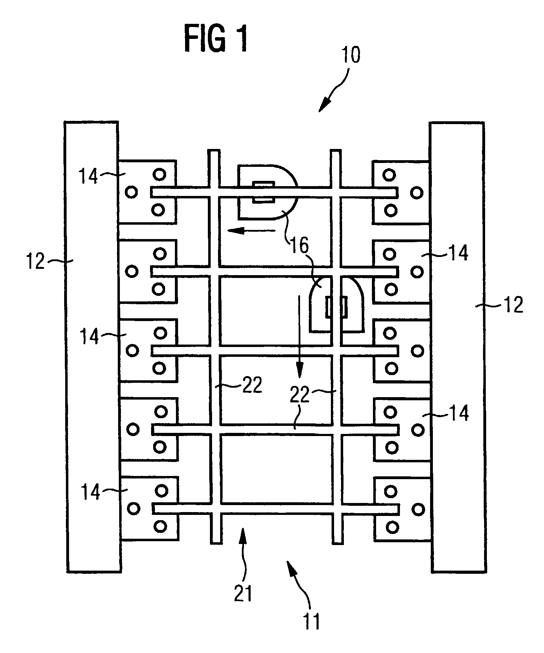

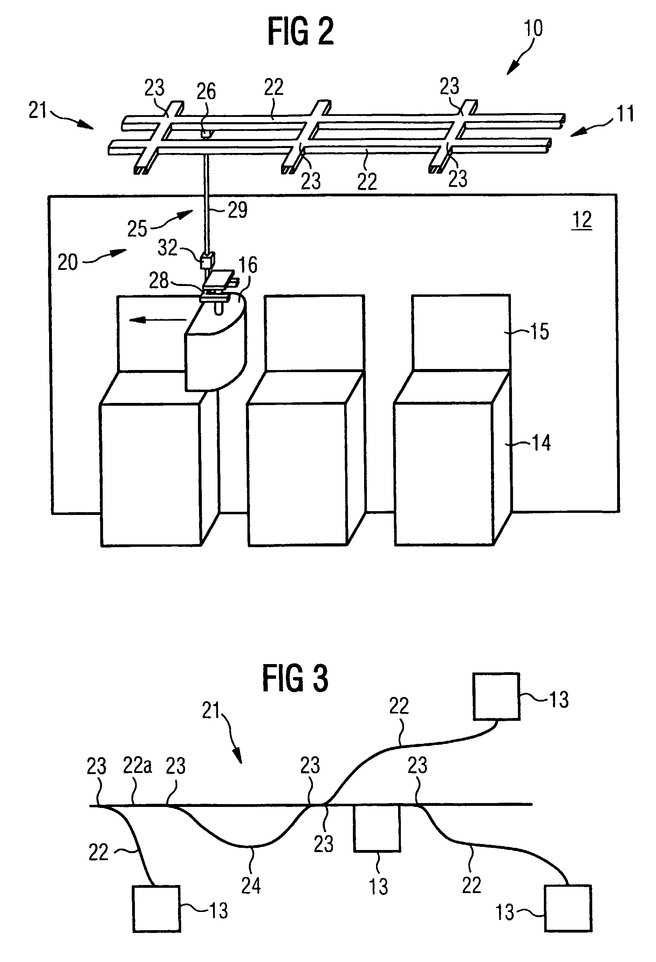

In Figs.1 and 2 an environment 10 with clean room class one or less is illustrated which serves as a fabrication for semiconductor products such as wafers with a diameter up to 300mm and beyond, flat panels, CDs or the like.

In environment 10, two walls 12 are provided having a couple of storage areas 14 attached thereto. The storage areas 14 can be locked by a lid 15, respectively. They are used to store containers 16 under minienvironment conditions. Said containers 16 are designed as socalled FOUPs and serve to store a number of wafers under minienvironment conditions therein.

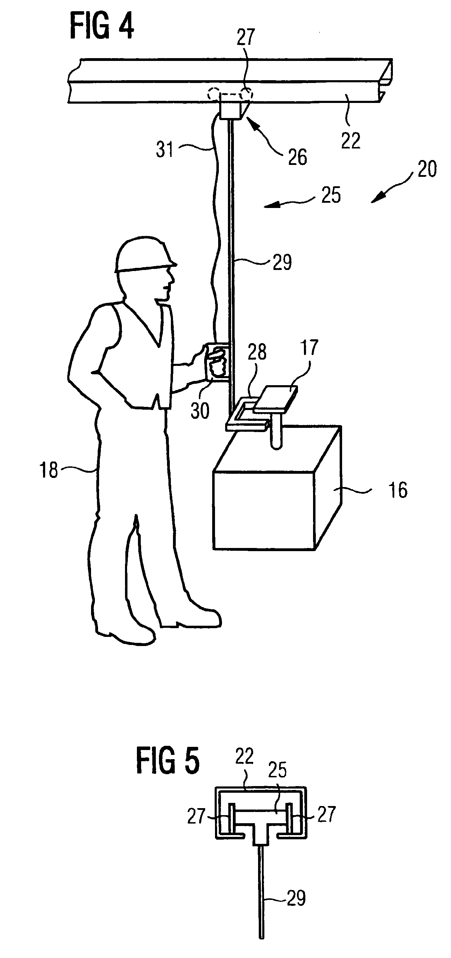

At a ceiling 11 of said environment 10 a sytem 21 of tracks 22 is provided. The system 21 comprises a number of tracks 22, which are connected by branching points 23 in order to provide a "network" of different tracks. This system 21 of tracks 22 is part of an arrangement 20 for manually moving a container 16. In addition to said tracks 22, arrangement 20 comprises at least one device 25 for supporting and moving a container 16. Device 25 comprises a conveying means 26, which will be described in more detail with respect to Figs.4 and 5. Furthermore, device 25 comprises a holding means 28 for gripping and holding the container 16 to be moved. Holding means 16 is attached to conveying means 26 via a suspension means 29, which is formed as a rope, line or cord in the present embodiment.

The arrangement 20 according to the present invention allows an operator to manually move the container 16 or containers great distances without any threat of injury, since it offers support to the operator during the transport of the container 16. The container 16 is held by the holding means 28 and therefore, the operator does not have to carry the container by hand. Through the system 21 of tracks 22 and through the device 25 for supporting and moving said container 16, which is movably attached to the system 21 of tracks 22, the container 16 being held by said holding means 28 can be moved very easy by the operator to every desired location within said environment 10. Said location may be a processing station 13 (see Fig.3), a storage area 14 or the like. Therefore, the arrangement 10 may be used according to the basic idea of "moving a curtain".

In order to ensure a smooth movement of the container 16 and to avoid that the wafers stored within said container 16 are rattled or tossed during its movement a suitable stabilizing means 32 is provided. Saif stabilizing means 32 can be a gyroscope, which per se is known in the art and which is provided in the area of the top of said container 16.

Fig.3 shows an example for a system 21 of tracks 22. System 21 comprises one main track 22a and several other tracks 22, which branch off from main track 22a and which lead to processing stations 13. Tracks 22 are connected to main track 22a via respective branching points 23. Furthermore, system 21 according to Fig.3 comprises at least one bypass-track 24 which is connected to main track 22a via respective branching points 23. The purpose of such a bypass-track 24 is to move two different containers 16 past one another. Otherwise, the bypass-tracks 24 may also be used to store the container 16 or containers in case that they are not needed for the moment.

As evident from Figs.4 and 5, the tracks 22, as well as those branching points 23 and bypass-tracks 24 may be formed as profiled guiding rails. One preferred shape for such profiled guiding rails is shown in the drawings. The profiled track 22 has an essentially rectangular cross-section and is provided with a slit at its bottom. Through said slit, a portion of conveying means 26 may descend. Conveying means 26 comprises four rollers 27 which run within said profiled tracks 22. Attached to conveying means 26 is suspension means 29, which is formed as a rope, line or cord. At the free end of rope 29, holding means 28 is attached. Said means 28 has a U-shaped configuration, in order to grip and hold a top handling flange 17 of container 16.

Furthermore, device 25 for supporting and moving container 16 comprises a handle 30. Said handle 30 can be used by the operator 18 for manually moving said container 16, that is to manually push or pull the container 16 along the tracks 22.

Moreover, device 25 comprises a control means 31. In the present embodiment, control means 31 has a branching signal wire which operates respective switches in the profiles 22, said switches being located in the the area of branching points 23, in order to allow a branching or diverting of container 16 hanging at rope 29.

Now, a method of manually moving container 16 will be described. For the movement of container 16 through environment 10, the operator will hang container 16 into the holding means 28, for example a gripper. Said holding means 28 is hanging down from the tracks 22 at the ceiling 11 by the rope 29 which is attached to conveying means 26. Then operator 18 moves the hanging container 16 by pushing or pulling rope 29 via handle 30. The rope 29 will be guided by those small rollers 27, which are part of conveying means 26 and which run within those profiled tracks 22 being mounted at the ceiling 11 of environment 10.

As an example, if the container 16 is moved along main track 22a according to Fig.3 and if container 16 has to be moved to one of said processing stations 13 as its final destination, one or more of said branching points 23 have to be operated. When container 16 reaches a respective branching point 23, operator 18 works control means 31, which itself operates a respective switch within profiled track 22a. After said operation has been finished, container 16 can leave ist momentary moving direction along main track 22a and can be moved along a track 22 to the desired processing station 13.

## Claims

1. An arrangement for manually moving a container (16) for storing objects, particularly for storing disklike objects such as wafers, flat panels or CDs, through an environment (10), particularly through a fabrication, comprising a system (21) of overhead tracks (22) and a device (25) for supporting and moving said container (16), said device (25) comprising a conveying means (26) which is movable along said tracks (22) and a holding means (28) for holding said container (16), said holding means (28) being attached to said conveying means (26) via a suspension means (29).

2. The arrangement according to claim 1,
**characterized in**
that said tracks (22) are formed as profiled guiding rails.

3. The arrangement according to claim 1 or 2,
**characterized in**
that said system (21) of overhead tracks (22) comprises one or more branching points (23).

4. The arrangement according to anyone of claims 1 to 3,
**characterized in**
that said system (21) of overhead tracks (22) comprises one or more bypass-tracks (24).

5. The arrangement according to anyone of claims 1 to 4,
**characterized in**
that said conveying means (26) comprises one or more rollers (27) or wheels.

6. The arrangement according to anyone of claims 1 to 5,
**characterized in**
that said suspension means (29) is formed as a cord, line, rope or rod, particularly as a telescopic rod.

7. The arrangement according to anyone of claims 1 to 6,
**characterized in**
that a handle (30) is provided, which is preferably attached to said suspension means (29).

8. The arrangement according to anyone of claims 1 to 7,
**characterized in**
that a stabilizing means is provided for preventing a tilt of said container (16) during its movement.

9. The arrangement according to anyone of claims 1 to 8,
**characterized in**
that a control means (31) for controlling the movement of said conveying means (26) at said branching points (23) and/or said bypass-tracks (24) is provided, said control means (31) particularly being attached to said suspension means (29) or to said handle (30).

10. The arrangement according to anyone of claims 1 to 9,
**characterized in**
that said container (16) is a minienvironment-container, particularly a Front-Opening-Unified-Pod (FOUP).

11. A method for manually moving a container for storing objects through an environment, particularly through a fabrication, by use of an arrangement according to anyone of claims 1 to 10, said method comprising the steps of:
a) picking up and holding said container by aid of said holding means;
b) conveying said container through said environment such that said device for supporting and moving said container is manually moved via its conveying means along the system of overhead tracks.

12. The method according to claim 11,
**characterized in**
that said device for supporting and moving said container is manually pushed or pulled by an operator.
